# EUROPEAN PATENT APPLICATION

(11) **EP 4 687 315 A1**
(43) Date of publication of application: **04.02.2026**
(21) Application number: 24777469.8
(22) Date of filing: 22.01.2024
(51) Int. Cl.: H04L 1/00

(54) **ENCODING METHOD, DECODING METHOD, COMMUNICATION NODE AND STORAGE MEDIUM**

(30) Priority: 28.03.2023 CN 202310314255
(71) Applicant: ZTE Corporation, Shenzhen, Guangdong 518057 (CN)
(72) Inventor: JIANG, Yi, Shenzhen, Guangdong 518057 (CN); YUAN, Liquan, Shenzhen, Guangdong 518057 (CN); ZHANG, Weiliang, Shenzhen, Guangdong 518057 (CN)
(74) Representative: Aipex B.V.
(86) International application number: PCT/CN2024/073469
(87) International publication number: WO 2024/198674

(57) **Abstract**

Provided are an encoding method, a decoding method, a communication node, and a storage medium. The encoding method includes the following: An uncoded physical frame is acquired, where the uncoded physical frame includes a first data block and a second data block, and the first data block includes a type of a flexible forward error correction, FEC, code. The second data block is encoded according to the type of the flexible FEC code.

## Description

### TECHNICAL FIELD

The present application relates to the field of communication technology, for example, to an encoding method, a decoding method, a communication node, and a storage medium.

### BACKGROUND

Current standards specify that a passive optical network (PON) system transmits data in the downstream direction through broadcast, multicast, or unicast methods. Due to the point-to-multipoint (P2MP) topology of the optical distribution network (ODN), all optical network units (ONUs) receive the same downstream data. To meet bit error rate requirements, forward error correction (FEC) code is typically used in the downstream direction to reduce the bit error ratio (BER) at the receiving end. Although the channel quality from each optical line terminal (OLT) to an ONU varies, since the ONUs receive the same data, it is unclear which data is intended for which ONU(s) before decoding and extracting the frame header. Consequently, even if the channel quality from an OLT to an ONU is good, requiring no high-performance but bandwidth-intensive FEC code to reduce the BER at the receiving ONU, a solution where all user data is encoded with the same FEC to ensure that even the worst-performing ONU meets the standard requirements is adopted. Therefore, how to allocate bandwidth more reasonably and reduce the bandwidth overhead caused by uniform FEC code has become an urgent issue to address.

### SUMMARY

Embodiments of the present application provide an encoding method. The method is applied to a first communication node and includes operations below.

An uncoded physical frame is acquired, where this uncoded physical frame includes a first data block and a second data block, and the first data block includes a type of a flexible FEC code.

The second data block is encoded according to the type of the flexible FEC code.

Embodiments of the present application provide a decoding method. The method is applied to a second communication node and includes operations below.

A type of a flexible FEC code is determined.

Second type codewords of encoded data are decoded according to the type of the flexible FEC code to obtain a second data block.

Embodiments of the present application provide a first communication node. The first communication node includes a processor that, when executing a computer program, implements the encoding method of any of the preceding embodiments.

Embodiments of the present application provide a second communication node. The second communication node includes a processor that, when executing a computer program, implements the decoding method of any of the preceding embodiments.

Embodiments of the present application also provide a computer-readable storage medium storing a computer program that, when executed by a processor, implements the method of any of the preceding embodiments.

The preceding embodiments and other aspects of the present application and implementations thereof are described in more detail in the description of drawings, detailed description, and claims.

### BRIEF DESCRIPTION OF DRAWINGS

FIG. 1 is a diagram illustrating the networking of a PON system according to an embodiment.
FIG. 2 is a flowchart of an encoding method according to an embodiment.
FIG. 3 is a flowchart of a decoding method according to an embodiment.
FIG. 4 is a diagram illustrating the interaction of data transmission between an OLT and an ONU according to an embodiment.
FIG. 5 is a diagram illustrating the structure of a PHY frame according to an embodiment.
FIG. 6 is a diagram illustrating the structure of another PHY frame according to an embodiment.
FIG. 7 is a diagram illustrating the structure of a physical synchronization block, downstream (PSBd) according to an embodiment.
FIG. 8 is a diagram illustrating the structure of an operation and control body (OC body) field according to an embodiment.
FIG. 9 is another diagram illustrating the interaction of data transmission between an OLT and an ONU according to an embodiment.
FIG. 10 is a diagram illustrating the structure of another PHY frame according to an embodiment.
FIG. 11 is another diagram illustrating the interaction of data transmission between an OLT and an ONU according to an embodiment.
FIG. 12 is a diagram illustrating the structure of still another PHY frame according to an embodiment.
FIG. 13 is a diagram illustrating the structure of a framing sublayer (FS) frame according to an embodiment.
FIG. 14 is a diagram illustrating the structure of a newly defined downstream PHY frame header according to an embodiment.
FIG. 15 is a flowchart of an encoding process according to an embodiment.
FIG. 16 is a flowchart of a decoding process according to an embodiment.
FIG. 17 is a diagram illustrating the structure of another newly defined downstream PHY frame header according to an embodiment.
FIG. 18 is a diagram of a downstream burst transmission according to an embodiment.
FIG. 19 is a diagram illustrating the structure of a downstream burst structure according to an embodiment.
FIG. 20 is a diagram illustrating the structure of a downstream FS burst structure without a framing sublayer tailer (FS tailer) according to an embodiment.
FIG. 21 is a diagram illustrating the structure of a downstream FS burst structure with an FS tailer according to an embodiment.
FIG. 22 is a diagram illustrating the structure of an encoding apparatus according to an embodiment.
FIG. 23 is a diagram illustrating the structure of another encoding apparatus according to an embodiment.
FIG. 24 is a diagram illustrating the structure of a decoding apparatus according to an embodiment.
FIG. 25 is a diagram illustrating the structure of another decoding apparatus according to an embodiment.
FIG. 26 is a diagram illustrating the structure of a communication node according to an embodiment.

### DETAILED DESCRIPTION

It is to be understood that the specific embodiments described herein are intended to explain the present application and not to limit the present application. Embodiments of the present application are described hereinafter in detail in conjunction with drawings.

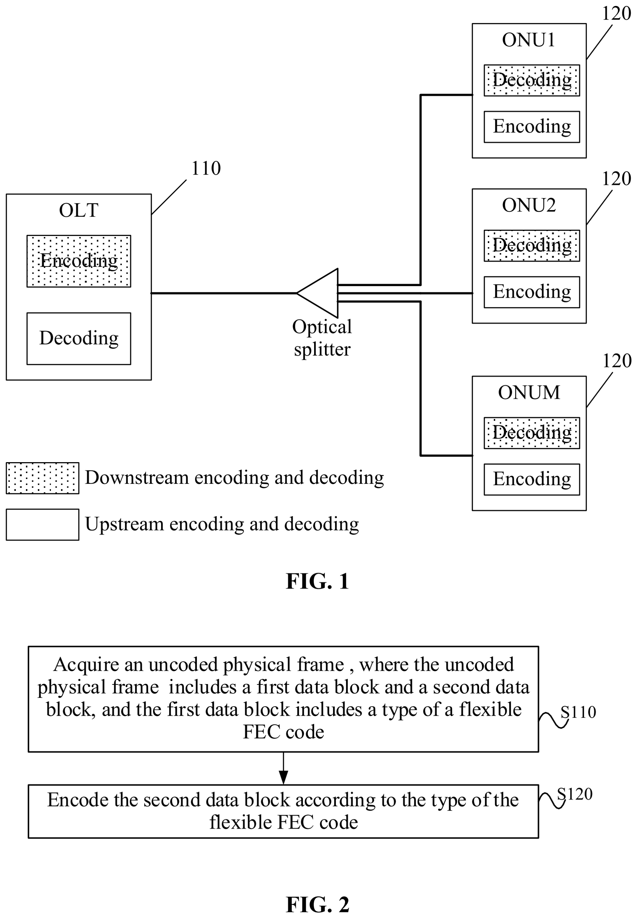

The encoding method and decoding method provided by the present application may be applied to various wireless communication systems, such as a PON system and new communication systems emerging in future communication development. FIG. 1 is a diagram illustrating the networking of a PON system according to an embodiment. As shown in FIG. 1, the PON system includes an OLT 110 and ONUs 120, where M ONUs 120 are provided in FIG. 1. The OLT 110 communicates with multiple ONUs 120 through an optical splitter. The PON system may also include other network devices, such as user terminals, servers, and mobile base stations. In the topology shown in FIG. 1, communication nodes may be classified into "user side" and "network side" based on the connection relationships of the communication nodes. In the PON system, the communication direction from OLT 110 to ONU 120 is referred to as downstream encoding and decoding, where OLT 110 sends encoded data blocks to ONU 120, and ONU 120 then decodes the encoded data blocks; the communication direction from ONU 120 to OLT 110 is referred to as upstream encoding and decoding, where ONU 120 sends encoded data blocks to OLT 110, and OLT 110 then decodes the encoded data blocks.

Embodiments of the present application provide an encoding method, an decoding method, a communication node, and a storage medium that may be operated in the preceding wireless communication systems, which enable encoding and decoding using different FEC code types based on the channel quality from each OLT to an ONU, allow reasonable bandwidth allocation and optimization for each OLT-to-ONU channel, and improve the flexibility and real-time performance of FEC of the system, thereby enhancing bandwidth utilization of the system.

The encoding method, decoding method, communication node, and their technical effects are described below.

FIG. 2 is a flowchart of an encoding method according to an embodiment. As shown in FIG. 2, the method provided in this embodiment is applicable to a first communication node. In this example, the first communication node (also referred to as the first communication node device) may be an OLT. The method includes S110 and S120.

In S110, an uncoded physical frame is acquired, where the uncoded physical frame includes a first data block and a second data block, and the first data block includes a type of a flexible FEC code.

In S120, the second data block is encoded according to the type of the flexible FEC code.

In an embodiment, after the second data block is encoded, encoded data may be sent to a second communication node. The encoded data includes the first data block and a second type codewords, and the second type codewords present the encoded second data block.

In an embodiment, in addition to the second data block being encoded, the first data block may be encoded according to a type of a dedicated FEC code in the present application. Accordingly, after the first data block and the second data block are encoded, encoded data may be sent to the second communication node. The encoded data includes first type codewords and second type codewords. The first type codewords present the encoded first data block, and the second type codewords present the encoded second data block.

When both the first data block and the second data block are encoded, the type of the dedicated FEC code used for encoding the first data block may be the same as or different from the type of the flexible FEC code used for encoding the second data block.

In an embodiment, the uncoded physical frame is an uncoded physical frame in a continuous transmission mode or an uncoded physical frame in a downstream burst mode. That is, the present application is applicable to both the continuous transmission mode and the downstream burst mode.

If the uncoded physical frame is an uncoded physical frame in the continuous transmission mode, the structures of the first data block and the second data block may be any of the following cases:

Case 1.1: The first data block at least includes a PSBd, and the second data block includes at least part of an FS frame.

The type of the flexible FEC code is indicated by a physical synchronization (PSync) sequence of the PSBd, where different PSync sequences indicate different FEC codes. Alternatively, the type of the flexible FEC code is indicated jointly by a downstream forward error correction (DS FEC) flag bit and a reserved bit in an OC body field of the PSBd.

Case 1.2: The first data block at least includes a PSBd and an FS frame header, and the second data block includes an FS frame payload.

The type of the flexible FEC code is indicated in an HLend field of the FS frame header.

Case 1.3: The first data block includes an extended physical synchronization block, downstream (ePSBd) and a forward error correction mapping (FECmap) structure, and the second data block includes an FS frame.

The type of the flexible FEC code is indicated jointly by a forward error correction type (FEC type) field in the ePSBd and the FECmap structure. Optionally, the number of flexible FEC codes is further indicated by a forward error correction count (FEC count) field in the ePSBd.

If the uncoded physical frame is an uncoded physical frame in the downstream burst mode, the structures of the first data block and the second data block may be any of the following cases:
Case 2.1: The first data block at least includes a PSBd, and the second data block at least includes part of a downstream physical burst structure.

The type of the flexible FEC code is indicated by a PSync sequence of the PSBd. Alternatively, the type of the flexible FEC code is indicated jointly by a DS FEC flag bit and a reserved bit in an OC body field of the PSBd.

Case 2.2: The first data block at least includes a PSBd and an FS frame header in a downstream physical burst structure, and the second data block at least includes an FS frame payload in the downstream physical burst structure.

The type of the flexible FEC code is indicated by an HLend field of the FS frame header.

Case 2.3: The first data block includes an ePSBd and an FECmap structure, and the second data block includes a downstream physical burst structure.

The type of the flexible FEC code is indicated jointly by an FEC type field in the ePSBd and the FECmap structure. Optionally, the type of the flexible FEC code is further indicated by an FEC count field in the ePSBd.

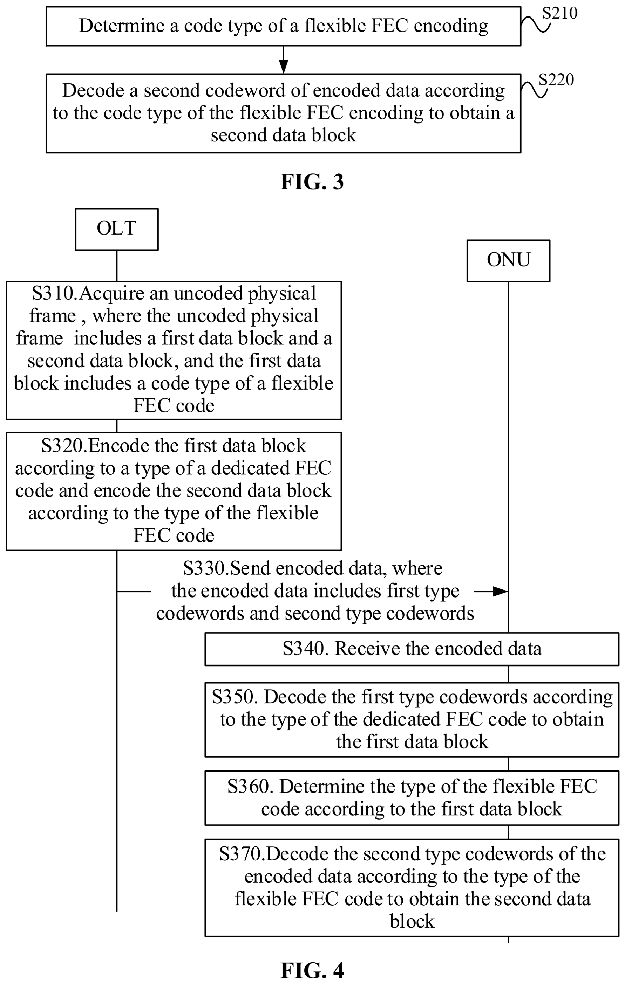

FIG. 3 is a flowchart of a decoding method according to an embodiment. As shown in FIG. 3, the method provided in this embodiment is applicable to a second communication node. In this example, the second communication node (also referred to as the second communication node device) may be an ONU. The method includes S210 and S220.

In S210, a type of a flexible FEC code is determined.

In an embodiment, before the type of the flexible FEC code is determined, encoded data sent by a first communication node is first received. The encoded data includes a first data block and second type codewords or includes first type codewords and second type codewords.

If the encoded data includes the first data block and the second type codewords, the method for determining the type of the flexible FEC code may be determining the type of the flexible FEC code according to the first data block.

If the encoded data includes the first type codewords and the second type codewords, the method for determining the type of the flexible FEC code may include first decoding the first type codewords according to a type of a dedicated FEC code to obtain the first data block; then determining the type of the flexible FEC code according to the first data block.

In an embodiment, the type of the dedicated FEC code used for decoding the first data block may be the same as or different from the type of the flexible FEC code used for decoding the second data block.

In S220, second type codewords of encoded data are decoded according to the type of the flexible FEC code to obtain a second data block.

In an embodiment, the encoded data is encoded data in a continuous transmission mode or encoded data in a downstream burst mode. That is, the present application is applicable to both the continuous transmission mode and the downstream burst mode.

If the encoded data is encoded data in the continuous transmission mode, the structures of the first data block and the second data block may be any of the following cases:
Case 3.1: The first data block at least includes a PSBd, and the second data block at least includes part of an FS frame.

The type of the flexible FEC code is indicated by a PSync sequence of the PSBd. Alternatively, the type of the flexible FEC code is indicated jointly by a DS FEC flag bit and a reserved bit in an OC body field of the PSBd.

Case 3.2: The first data block at least includes a PSBd and an FS frame header, and the second data block includes an FS frame payload.

The type of the flexible FEC code is indicated by an HLend field of the FS frame header.

Case 3.3: The first data block includes an extended physical synchronization block, downstream (ePSBd) and an FECmap structure, and the second data block includes an FS frame.

The type of the flexible FEC code is indicated jointly by an FEC type field in the ePSBd and the FECmap structure. Optionally, the number of flexible FEC codes is further indicated by the FEC count field in the ePSBd.

If the encoded data is encoded data in the downstream burst mode, the structures of the first data block and the second data block may be any of the following cases:
Case 4.1: The first data block at least includes a PSBd, and the second data block at least includes part of a downstream physical burst structure.

The type of the flexible FEC code is indicated by a PSync sequence of the PSBd. Alternatively, the type of the flexible FEC code is indicated jointly by a DS FEC flag bit and a reserved bit in an OC body field of the PSBd.

Case 4.2: The first data block at least includes a PSBd and an FS frame header in a downstream physical burst structure, and the second data block at least includes an FS frame payload in the downstream physical burst structure.

The type of the flexible FEC code is indicated by an HLend field of the FS frame header.

Case 4.3: The first data block includes an ePSBd and an FECmap structure, and the second data block includes a downstream physical burst structure.

The type of the flexible FEC code is indicated jointly by an FEC type field in the ePSBd and the FECmap structure. Optionally, the number of flexible FEC codes is further indicated by the FEC count field in the ePSBd.

Specific implementations are provided below to illustrate the encoding method and decoding method provided by embodiments of the present application.

In a first possible implementation, FIG. 4 is a diagram illustrating the interaction of data transmission between an OLT and an ONU according to an embodiment. As shown in FIG. 4, S310 to S370 are included.

In S310, the OLT acquires an uncoded physical frame, where the uncoded physical frame includes a first data block and a second data block, and the first data block includes a type of a flexible FEC code.

In this implementation, the structure of the uncoded physical frame may reuse the uncoded physical frame structure of the downstream direction in the continuous mode under existing standards. The OLT periodically sends encoded data (for example, with a period T = 125 µs). The first data block of the uncoded physical frame is modified to include the type of the flexible FEC code so that the downstream direction supports encoding and decoding with variable types of FEC code.

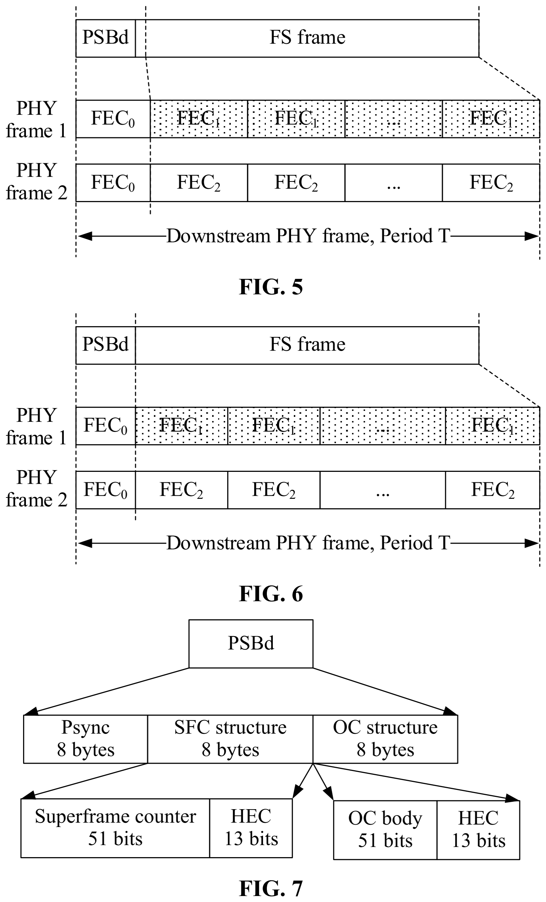

FIG. 5 is a diagram illustrating the structure of an uncoded physical frame according to an embodiment. FIG. 6 is a diagram illustrating the structure of another uncoded physical frame according to an embodiment. As shown in FIG. 5 and FIG. 6, a downstream PHY frame corresponding to one period T includes a PSBd and an FS frame. During encoding performed by the OLT, the OLT may, as shown in FIG. 5, encode the PSBd and a portion of the FS frame as the first data block to form one codeword, that is, FEC₀ and encode the remaining data of the FS frame as the second data block to form multiple codewords, that is, multiple FEC₁s; alternatively, as shown in FIG. 6, the OLT may encode the PSBd as the first data block to form one codeword, that is, FEC₀ and encode the FS frame as the second data block to form multiple codewords, that is, multiple FEC₂s. In FIG. 5 and FIG. 6, PHY frame 1 indicates that the FEC code types used for encoding FEC₀ and FEC₁ are different; PHY frame 2 indicates that the FEC code types used for encoding FEC₀ and FEC₂ are the same.

In S320, the OLT encodes the first data block according to a type of a dedicated FEC code and encodes the second data block according to the type of the flexible FEC code.

The type of the dedicated FEC code is an FEC code type that can be recognized by all ONUs, such as a default FEC code type or a specific FEC code type (for example, a Reed-Solomon forward error correction (RS FEC) code type).

The type of the flexible FEC code is indicated in the first data block.

FIG. 7 is a diagram illustrating the structure of a PSBd according to an embodiment. As shown in FIG. 7, the PSBd includes a PSync sequence, a superframe counter structure (SFC structure), and an operation and control structure (OC structure), where the SFC structure includes a superframe counter field and a hybrid error correction (HEC) field, and the OC structure includes an OC body field and an HEC field.

In an example, the type of the flexible FEC code is indicated by the PSync sequence of the PSBd. The PSync sequence is used for synchronization by the ONU upon reception. By construction of different PSync sequences, different PSync sequences correspond to different types of FEC code. A correspondence table between PSync sequences and types of the flexible FEC code is preconfigured by the OLT network management, and both the OLT and ONU use this correspondence table.

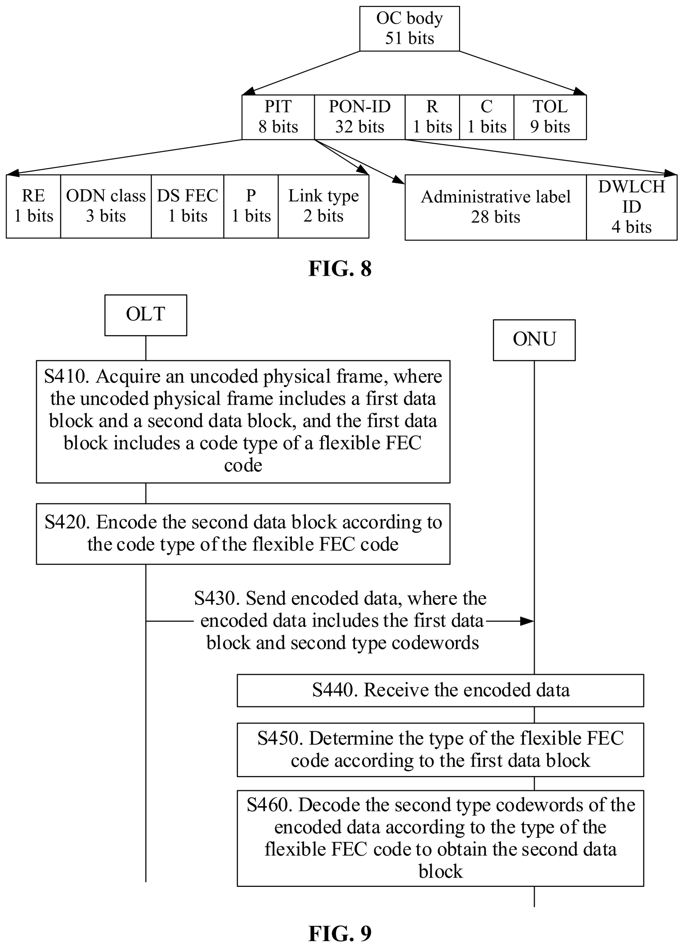

In another example, FIG. 8 is a diagram illustrating the structure of an OC body field according to an embodiment. As shown in FIG. 8, the type of the flexible FEC code is indicated jointly by a DS FEC flag bit and a reserved bit in an OC body field of the PSBd. That is, the meaning of the DS FEC flag bit and the reserved bits R in the standard OC body field is modified to achieve flexible switching among three different FEC code types by using these two bits.

For example, setting the DS FEC flag bit to 1 indicates the use of the type of the dedicated FEC code, and the value of R is ignored by the ONU; setting the DS FEC flag bit to 0 indicates the use of the type of the flexible FEC code, and the value of R represents different types of FEC code. For instance, if R = 0, the OLT uses type 1 for encoding, and the ONU uses type 1 for decoding; if R = 1, the OLT uses type 2 for encoding, and the ONU uses type 2 for decoding.

In S330, the OLT sends encoded data to the ONU, where the encoded data includes first type codewords and second type codewords, the first type codewords present an encoded first data block, and the second type codewords present an encoded second data block.

In S340, the ONU receives the encoded data sent by the OLT.

In S350, the ONU decodes the first type codewords according to the type of the dedicated FEC code to obtain the first data block.

In S360, the ONU determines the type of the flexible FEC code according to the first data block.

Accordingly, after the ONU decodes the first type codewords according to the type of the dedicated FEC code to obtain the first data block, the ONU may determine the type of the flexible FEC code indicated by the PSync sequence in the PSBd or may determine the type of the flexible FEC code jointly indicated by the DS FEC flag bit and a reserved bit in the OC body field of the PSBd.

In S370, the ONU decodes the second type codewords of the encoded data according to the type of the flexible FEC code to obtain the second data block.

In a second possible implementation, FIG. 9 is another diagram illustrating the interaction of data transmission between an OLT and an ONU according to an embodiment. As shown in FIG. 9, S410 to S460 are included.

In S410, the OLT acquires an uncoded physical frame, where the uncoded physical frame includes a first data block and a second data block, and the first data block includes a type of a flexible FEC code.

In this implementation, the requirement in existing standards that the PSBd is protected by FEC may be modified so that the PSBd is not protected by FEC, which is similar to the physical synchronization block, upstream (PSBu) frame header in existing standards. The OLT periodically sends encoded data (for example, with a period T = 125 µs). The first data block of the uncoded physical frame is modified to include the type of the flexible FEC code so that the downstream direction supports encoding and decoding with variable types of FEC code.

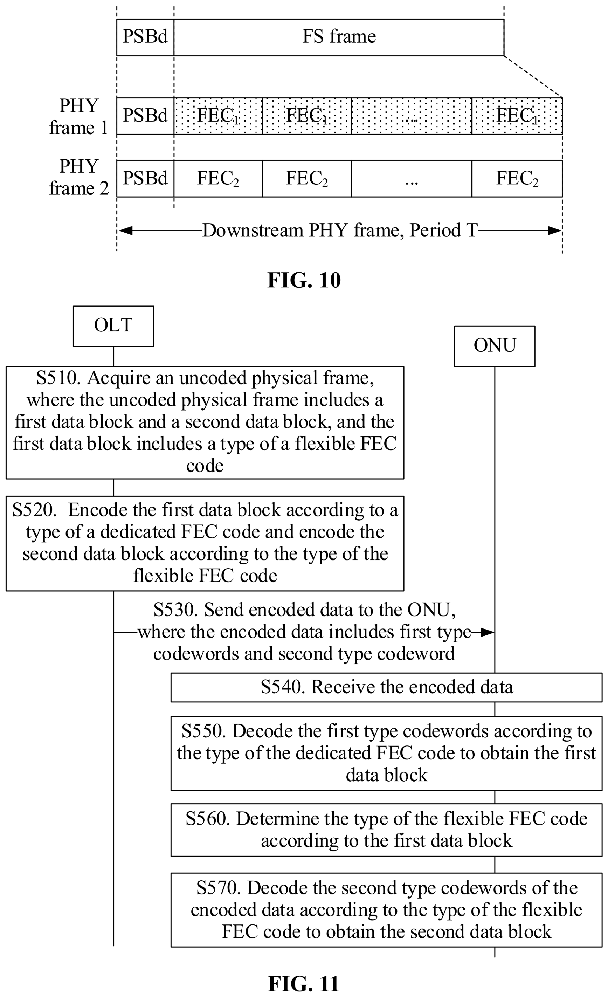

FIG. 10 is a diagram illustrating the structure of another PHY frame according to an embodiment. As shown in FIG. 10, a downstream PHY frame corresponding to one period T includes a PSBd and an FS frame. The PSBd serves as the first data block, and the FS frame serves as the second data block. During encoding performed by the OLT, the OLT does not encode the first data block but encodes the second data block to form multiple codewords, that is, multiple FEC₁s or multiple FEC₂s. In FIG. 10, PHY frame 1 indicates that the FEC code type used for FEC₁ is not the type of the dedicated FEC code; PHY frame 2 indicates that the FEC code type used for FEC₂ is the type of the dedicated FEC code.

In S420, the OLT encodes the second data block according to the type of the flexible FEC code.

The type of the flexible FEC code is indicated in the first data block. Specifically, the indication method for the type of the flexible FEC code is the same as that in the first possible implementation described above and is not repeated here for brevity.

In S430, the OLT sends encoded data to the ONU, where the encoded data includes the first data block and second type codewords, and the second type codewords present an encoded second data block.

In S440, the ONU receives the encoded data sent by the OLT.

In S450, the ONU determines the type of the flexible FEC code according to the first data block.

In S460, the ONU decodes the second type codewords of the encoded data according to the type of the flexible FEC code to obtain the second data block.

In a third possible implementation, FIG. 11 is another diagram illustrating the interaction of data transmission between an OLT and an ONU according to an embodiment. As shown in FIG. 11, S510 to S570 are included.

In S510, the OLT acquires an uncoded physical frame, where the uncoded physical frame includes a first data block and a second data block, and the first data block includes a type of a flexible FEC code.

In this implementation, the structure of the uncoded physical frame may reuse the uncoded physical frame structure of the downstream direction in the continuous mode under existing standards. The OLT periodically sends encoded data (for example, with a period T = 125 µs). The first data block of the uncoded physical frame is modified to include the type of the flexible FEC code so that the downstream direction supports encoding and decoding with variable types of FEC code.

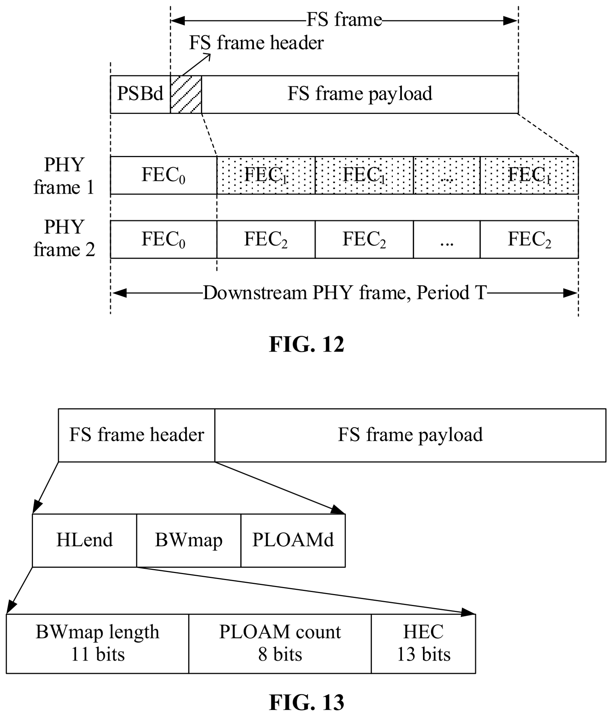

FIG. 12 is a diagram illustrating the structure of still another PHY frame according to an embodiment. As shown in FIG. 12, a downstream PHY frame corresponding to one period T includes a PSBd and an FS frame, and the FS frame includes an FS frame header and an FS frame payload. During encoding performed by the OLT, the OLT may encode the PSBd and the FS frame header as the first data block to form one codeword, that is, FEC₀ and encode the FS frame payload as the second data block to form multiple codewords, that is, multiple FEC₁s or multiple FEC₂s. In FIG. 12, PHY 1 indicates that the FEC code types used for encoding FEC₀ and FEC₁ are different; PHY 2 indicates that the FEC code types used for encoding FEC₀ and FEC₂ are the same.

It should be noted that when the PSBd and the FS frame header are encoded as the first data block, if the data length of the PSBd and the FS frame header is less than the information bit length of the first type codewords, specific data may be used for padding.

In S520, the OLT encodes the first data block according to a type of a dedicated FEC code and encodes the second data block according to the type of the flexible FEC code.

The type of the dedicated FEC code is an FEC code type that can be recognized by all ONUs, such as a default FEC code type or a specific FEC code type (for example, an RS FEC type).

The type of the flexible FEC code is indicated in the first data block.

FIG. 13 is a diagram illustrating the structure of an FS frame according to an embodiment. As shown in FIG. 13, the FS frame includes an FS frame header and an FS frame payload. The FS frame header includes an HLend field, a bandwidth map (BWmap) field, and a downstream physical layer operations, administration, and maintenance (PLOAMd) message. The HLend field includes a bandwidth map length (BWmap length) field, a physical layer operations, administration, and maintenance count (PLOAM count) field, and an HEC field.

The type of the flexible FEC code is indicated by an HLend field of the FS frame header. Exemplarily, the HLend field indicates the type of the flexible FEC code used by the current uncoded physical frame.

For example, the HLend field is maintained at a 4-byte length as in existing standards, and the bit counts of the BWmap length field and the PLOAM count field are adjusted to free up 2 bits to indicate the type of the flexible FEC code for the current frame; alternatively, the length of the HLend field is increased, and 2 bits are used to indicate up to four different types of the flexible FEC code.

In S530, the OLT sends encoded data to the ONU, where the encoded data includes first type codewords and second type codewords, the first type codewords present an encoded first data block, and the second type codewords present an encoded second data block.

In S540, the ONU receives the encoded data sent by the OLT.

In S550, the ONU decodes the first type codewords according to the type of the dedicated FEC code to obtain the first data block.

All ONUs, upon receiving the downstream PHY frame, first decode the first type codewords of the downstream frame using the type of the dedicated FEC code to obtain the first data block.

In S560, the ONU determines the type of the flexible FEC code according to the first data block.

Accordingly, after the ONU decodes the first type codewords using the type of the dedicated FEC code to obtain the first data block, the ONU determines the type of the flexible FEC code indicated by the HLend field in the FS frame header.

In S570, the ONU decodes the second type codewords of the encoded data according to the type of the flexible FEC code to obtain the second data block.

In a fourth possible implementation, the OLT may periodically send encoded data under existing standards (for example, with a period T = 125 µs), modify the PSBd to an ePSBd, and add an FECmap structure. The ePSBd and FECmap structure are included in the first data block, and the type of the flexible FEC code is indicated jointly by an FEC type field in the ePSBd and the FECmap structure. Optionally, the type of the flexible FEC code is further indicated by an FEC count field in the ePSBd.

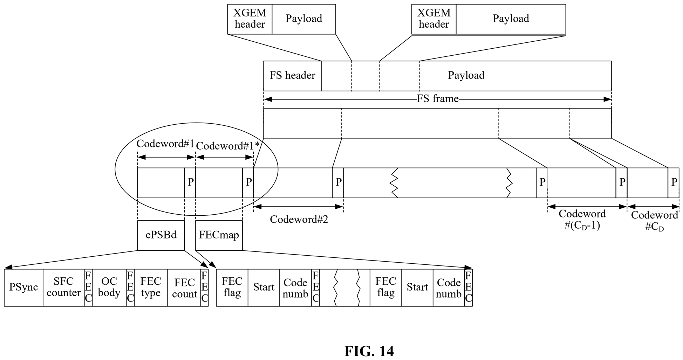

FIG. 14 is a diagram illustrating the structure of a newly defined downstream PHY frame header according to an embodiment. As shown in FIG. 14, the ePSBd may be individually protected by FEC, or the FECmap structure may be individually protected by FEC, both of which use a type of a dedicated FEC code recognizable by all ONUs. The type of the dedicated FEC code used by the ePSBd and the FECmap structure may be the same or different. Alternatively, the ePSBd and FECmap structure may be protected together using a fixed FEC code type, such as a low-density parity-check (LDPC) code compatible with legacy ONUs, such as LDPC (17280, 14592).

The method for indicating the type of the flexible FEC code jointly by the FEC type field in the ePSBd and the FECmap structure is as follows:

When FEC type = 0, it may indicate that the current frame, excluding the frame header, is encoded using the type of the dedicated FEC code. In this case, the FEC count value is ignored by the ONU (the default value may be 1), and the length of the 1st* codeword of the current PHY frame is 0.

When FEC type = 1, it may indicate that the current frame, excluding the frame header, is encoded using type 1 of the flexible FEC code. In this case, the FEC count value is ignored by the ONU (the default value may be 1), and the length of the 1st* codeword of the current PHY frame is 0.

When FEC type = 2, it may indicate that the current frame, excluding the frame header, is encoded using type 2 of the flexible FEC code. In this case, the FEC count value is ignored by the ONU (the default value may be 1), and the length of the 1st* codeword of the current PHY frame is 0.

When FEC type = 3, it may indicate that the current frame, excluding the frame header, is encoded using multiple FEC code types. In this case, the FEC count value cannot be ignored by the ONU, and the length of the 1st* codeword of the current PHY frame is non-zero and determined by the actual number of encoded codewords. The FECmap structure indicates the different FEC code types (FEC flag), the number of codewords (code numb), and relative starting positions (start) in the current frame after FEC code. The FECmap structure corresponds exactly to the encoded codewords and is determined by the OLT.

Type 1 and type 2 of the flexible FEC code may respectively be high-throughput or high-margin FEC types with better performance than the type of the dedicated FEC code.

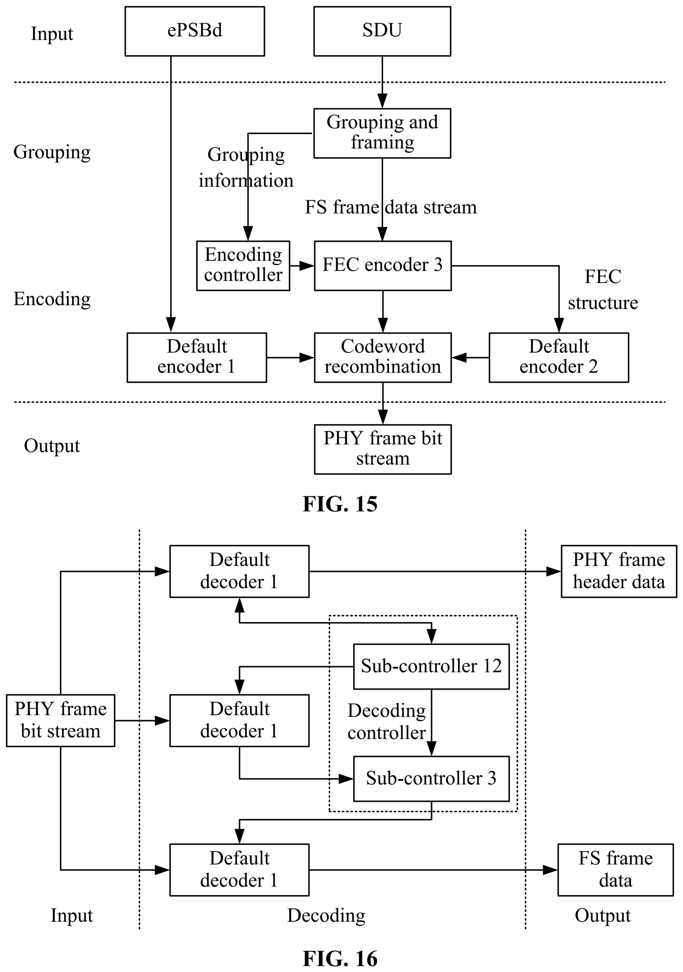

This implementation also provides a possible encoding method. FIG. 15 is a flowchart of an encoding process according to an embodiment. As shown in FIG. 15, service data units (SDUs) of various ONUs are grouped into different SDU categories by a framing module based on the FEC code types configured for the ONUs and then formed into FS frames according to the XG-PON encapsulation method (10-gigabit-capable PON encapsulation method, XGEM) and FS framing method in existing standards. Meanwhile, grouping information corresponding to the FS frames is sent to an encoding controller. It should be noted that although SDUs are grouped based on the FEC types configured for the ONUs, during the FS framing process, the OLT may place SDUs from different groups into the same FS frame based on the current load of user SDUs, provided that the grouping information clearly specifies the relative positions of XGEM frames corresponding to different groups in the FS frame payload. For example, the starting positions of XGEM frames of different groups in the FS payload are specified.

The encoding controller uses the grouping information to control FEC encoder 3, ensuring that XGEM frames of the same category are encoded with the same FEC type, and outputs the encoding structure of FEC encoder 3, which is the FECmap structure. The FECmap structure is encoded by a default FEC type of a dedicated default encoder 2.

The ePSBd is encoded by a default FEC type of another dedicated default encoder 1, which may be the same as or different from the default FEC type of default encoder 2.

Default encoder 1, default encoder 2, and FEC encoder 3 are used by a codeword recombination module to reassemble the downstream PHY frame, forming a bit stream of a physical (PHY) frame protected by FEC.

This implementation also provides a possible decoding method. FIG. 16 is a flowchart of a decoding process according to an embodiment. As shown in FIG. 16, after receiving the PHY frame bit stream, each ONU decodes it in three stages. First, default decoder 1 decodes the ePSBd protected by the dedicated FEC, which all ONUs can correctly decode.

ONU sub-controller 12 controls default decoder 2 to decode the FECmap part of the PHY frame bit stream, excluding the ePSBd part, based on the FEC type carried in the ePSBd. It is noted that if the FEC type indicates that the data length of the FECmap is 0, this operation does not process the remaining data of the PHY frame bit stream excluding the ePSBd part. Sub-controller 12 notifies sub-controller 3 to decode the remaining data.

ONU sub-controller 3 controls FEC decoder 3 to decode the remaining data of the PHY frame bit stream, excluding the ePSBd and FECmap parts. Decoding is performed according to the FEC structure in the FECmap to obtain the data for each ONU in the FS frame data.

Specific implementations include the following:

### 1. FEC decoding during ONU activation and registration phase

Method 1: During the activation and registration phase, if a PHY frame header with the PSBd structure is used, encoding and decoding follow the standard default process.
Method 2: During the activation and registration phase, if a PHY frame header with the ePSBd structure is used, the ONU needs to first decode the ePSBd. As shown in FIG. 14, if FEC type = 0, it indicates that the entire PHY frame uses the default code type, and the FEC count is ignored (it may have a default value, such as 1). In this case, the length of codeword #1* is 0, and no FECmap is present. Assuming the PHY frame has a total of C_{D} FEC codewords, the first codeword is for the ePSBd, and the second to the last codewords are FEC codes for the FS frame. The second to the (C_{D}+1)-th codewords are of the same length (L), while the length of the C_{D}-th codeword is not greater than L to ensure that the total bit count of the PHY frame for period T matches the bit count for the corresponding rate (for example, T = 125 µs). Alternatively, decoding may follow the conventional method, where the ePSBd and part of the FS frame data are protected by a single FEC, resulting in an additional FEC structure and HEC after decoding.

### 2. Decoding in the ONU working state

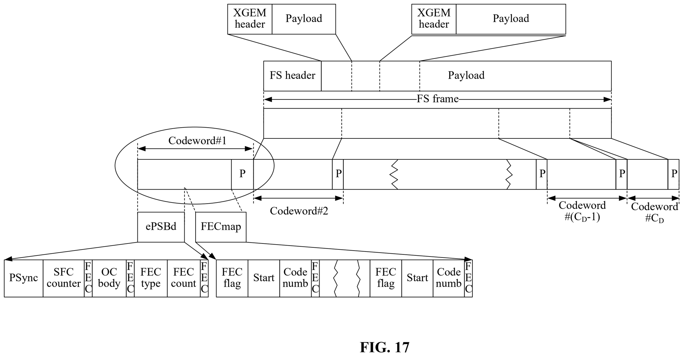

Operation 1: After factory settings or firmware upgrades, the FEC types supported by the ONU are known to the OLT, either through configuration or message inquiry, which is not limited by the present application.
Operation 2: In the working state, the ONU uses the frame header with the ePSBd structure throughout, and the first codeword #1 may be constructed in two possible manners: one as shown in FIG. 14, and the other as shown in FIG. 17.

Method 1: The ePSBd and FECmap together form codeword #1.

This method requires a fixed codeword length and uses specific FEC protection, such as the default code type in the standard; otherwise, different ONUs cannot perform decoding. The length of the FECmap may be 0 or another value L (fixed or non-fixed). This method may also require padding with specific data (such as idle data) to ensure the information bit length of codeword #1.

Method 2: The ePSBd alone forms codeword #1, the FECmap alone forms codeword #1*, and both are protected individually by default code types. The default FEC for codeword #1 and codeword #1* may be the same or different but must be code types supported by all ONUs by default and configurable (for example, by the OLT or network management). This method may also require padding with specific data (for example, idle data) to ensure the information bit length of codeword #1 and codeword #1*.

For the remaining data excluding the ePSBd, FEC protection may be applied in two cases:
(i) If the remaining part of the entire PHY frame is protected by only one FEC, FEC type = 0 may be set, indicating that only FEC₀ exists. In this case, the FEC count is ignored (it may have a default value, such as 1). In Method 1, the FECmap length is 0; in Method 2, codeword #1* does not exist, with length = 0. Similarly, FEC type = 1 may indicate that only FEC₁ exists, and FEC type = 2 may indicate that only FEC₂ exists.
(ii) If the remaining part of the entire PHY frame is protected by more than one FEC, FEC type = 3 may be set, indicating that multiple FECs exist. In this case, codeword #1* necessarily exists and has a fixed (or configurable) length to ensure all ONUs can perform decoding.

Operation 3: The ONU decodes codeword #1 using the default FEC (Method 1) or decodes codeword #1 and codeword #1* separately (Method 2), obtains the FEC structure, and determines the FEC used for the remaining data of the PHY frame, including the number of segments, FEC types, starting points, and the number of FEC codewords (if any) in the FECmap.

Operation 4: The ONU uses the FEC type and FECmap (if any) to decode the remaining part of the PHY frame.

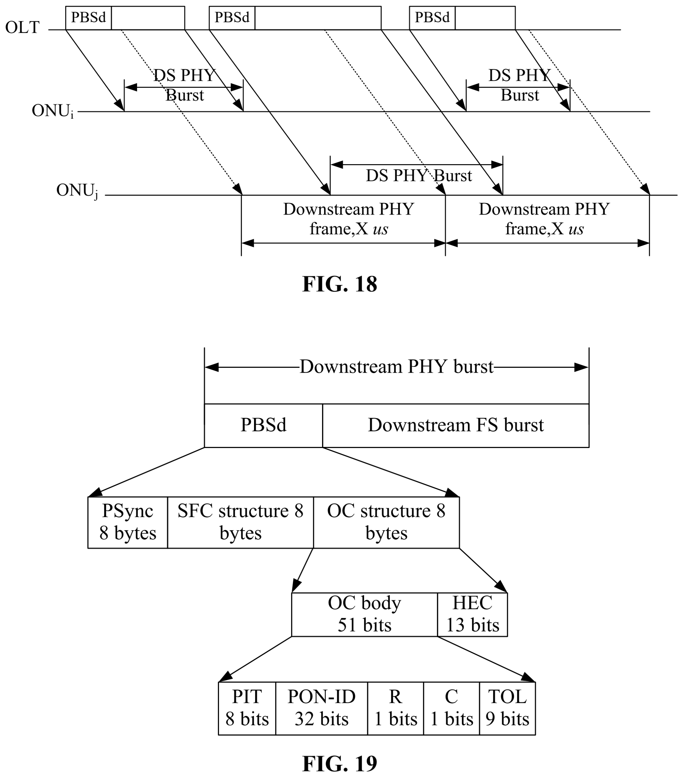

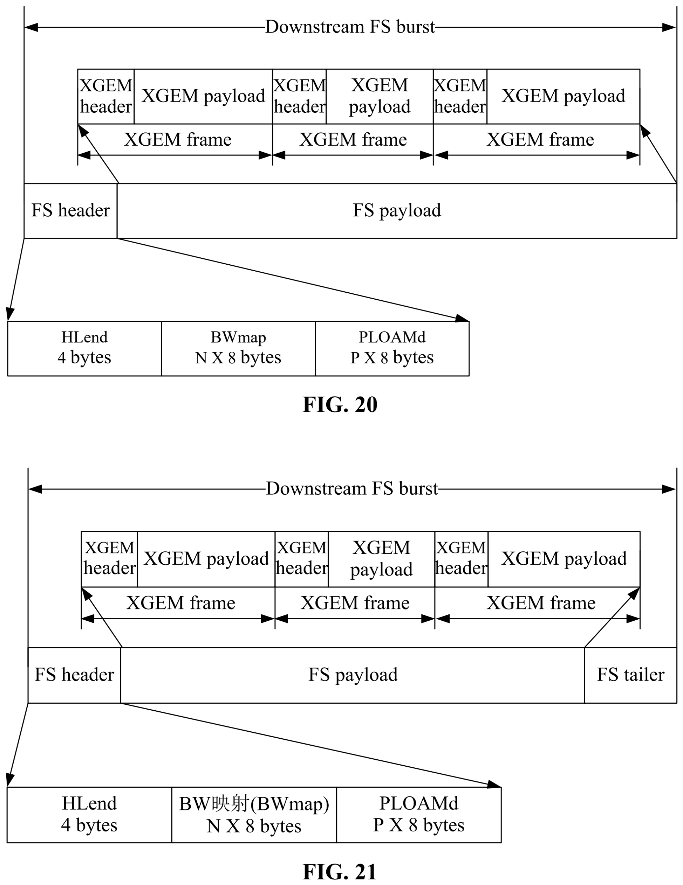

The preceding first to fourth possible implementations are all directed to the continuous transmission mode. The method provided by the present application is also applicable to the downstream burst mode. FIG. 18 is a diagram of a downstream burst transmission according to an embodiment. FIG. 19 is a diagram illustrating the structure of a downstream burst structure according to an embodiment. FIG. 20 is a diagram illustrating the structure of a downstream FS burst structure without an FS tailer according to an embodiment. FIG. 21 is a diagram illustrating the structure of a downstream FS burst structure with an FS tailer according to an embodiment.

As shown in FIG. 18 to FIG. 21, when data is transmitted in the downstream direction using the burst mode, the framing of the FS burst is the same as the framing process of the FS frame in the current common transmission convergence layer (ComTC) standard. If the downstream FS burst structure does not include an FS tailer, the multi-FEC framing method for the continuous transmission mode described above is fully applicable. If the downstream FS burst structure includes an FS tailer, the FS payload and FS tailer may be treated together as the payload of the downstream PHY burst, and the multi-FEC framing method for the continuous transmission mode described above is applicable. For brevity, repetition is not made here.

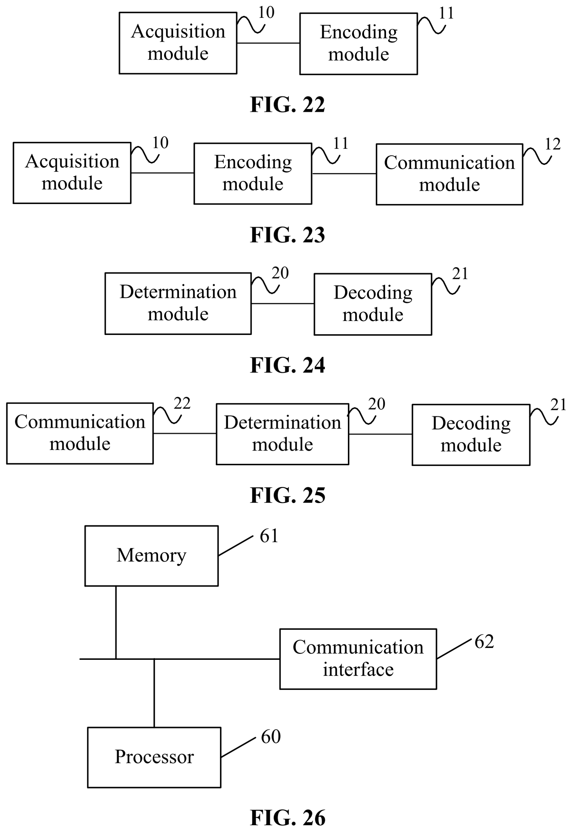

FIG. 22 is a diagram illustrating the structure of an encoding apparatus according to an embodiment. The apparatus may be configured in a first communication node. As shown in FIG. 22, the apparatus includes an acquisition module 10 and an encoding module 11.

The acquisition module 10 is configured to acquire an uncoded physical frame, where the uncoded physical frame includes a first data block and a second data block, and the first data block includes a type of a flexible FEC code.

The encoding module 11 is configured to encode the second data block according to the type of the flexible FEC code.

The encoding apparatus provided by this embodiment is used to implement the encoding method of the preceding embodiments. The implementation principles and technical effects of the encoding apparatus provided by this embodiment are similar to those of the preceding embodiments and are not repeated here.

In an embodiment, the encoding module 11 is also configured to encode the first data block according to a type of a dedicated FEC code.

In an embodiment, in combination with FIG. 22, FIG. 23 is a diagram illustrating the structure of another encoding apparatus according to an embodiment. The encoding apparatus also includes a communication module 12.

The communication module 12 is configured to send encoded data to a second communication node, where the encoded data includes the first data block and second type codewords or includes first type codewords and second type codewords, the first type codewords present an encoded first data block, and the second type codewords present an encoded second data block.

In an embodiment, the type of the dedicated FEC code is the same as or different from the type of the flexible FEC code.

In an embodiment, the uncoded physical frame is an uncoded physical frame in a continuous transmission mode or an uncoded physical frame in a downstream burst mode.

In an embodiment, when the uncoded physical frame is an uncoded physical frame in the continuous transmission mode, the first data block at least includes a PSBd, and the second data block at least includes part of an FS frame.

When the uncoded physical frame is an uncoded physical frame in the downstream burst mode, the first data block at least includes a PSBd, and the second data block at least includes part of a downstream physical burst structure.

In an embodiment, the type of the flexible FEC code is indicated by a PSync sequence of the PSBd. Alternatively, the type of the flexible FEC code is indicated jointly by a DS FEC flag bit and a reserved bit in an OC body field of the PSBd.

In an embodiment, when the uncoded physical frame is an uncoded physical frame in the continuous transmission mode, the first data block at least includes a PSBd and an FS frame header, and the second data block includes an FS frame payload.

When the uncoded physical frame is an uncoded physical frame in the downstream burst mode, the first data block at least includes a PSBd and an FS frame header in a downstream physical burst structure, and the second data block at least includes an FS frame payload in the downstream physical burst structure.

In an embodiment, the type of the flexible FEC code is indicated by an HLend field of the FS frame header.

In an embodiment, when the uncoded physical frame is an uncoded physical frame in the continuous transmission mode, the first data block includes an ePSBd and an FECmap structure, and the second data block includes an FS frame.

When the uncoded physical frame is an uncoded physical frame in the downstream burst mode, the first data block includes an ePSBd and an FECmap structure, and the second data block includes a downstream physical burst structure.

In an embodiment, the type of the flexible FEC code is indicated jointly by an FEC type field in the ePSBd and the FECmap structure.

In an embodiment, the type of the flexible FEC code is further indicated by an FEC count field in the ePSBd.

FIG. 24 is a diagram illustrating the structure of a decoding apparatus according to an embodiment. The apparatus may be configured in a second communication node. As shown in FIG. 24, the apparatus includes a determination module 20 and a decoding module 21.

The determination module 20 is configured to determine a type of a flexible FEC code.

The decoding module 21 is configured to decode second type codewords of encoded data according to the type of the flexible FEC code to obtain a second data block.

The decoding apparatus provided by this embodiment is used to implement the decoding method of the preceding embodiments. The implementation principles and technical effects of the decoding apparatus provided by this embodiment are similar to those of the preceding embodiments and are not repeated here.

In an embodiment, in combination with FIG. 24, FIG. 25 is a diagram illustrating the structure of another decoding apparatus according to an embodiment. The decoding apparatus also includes a communication module 22.

The communication module 22 is configured to receive the encoded data sent by a first communication node, where the encoded data includes a first data block and the second type codewords or includes first type codewords and the second type codewords.

In an embodiment, the determination module 20 is configured to determine the type of the flexible FEC code according to the first data block or to decode the first type codewords according to a type of a dedicated FEC code to obtain the first data block and determine the type of the flexible FEC code according to the first data block.

In an embodiment, the type of the dedicated FEC code is the same as or different from the type of the flexible FEC code.

In an embodiment, the encoded data is encoded data in a continuous transmission mode or encoded data in a downstream burst mode.

In an embodiment, when the encoded data is encoded data in the continuous transmission mode, the first data block at least includes a PSBd, and the second data block at least includes part of an FS frame.

When the encoded data is encoded data in the downstream burst mode, the first data block at least includes a PSBd, and the second data block at least includes part of a downstream physical burst structure.

In an embodiment, the type of the flexible FEC code is indicated by a PSync sequence of the PSBd. Alternatively, the type of the flexible FEC code is indicated jointly by a DS FEC flag bit and a reserved bit in an OC body field of the PSBd.

In an embodiment, when the encoded data is encoded data in the continuous transmission mode, the first data block at least includes a PSBd and an FS frame header, and the second data block includes an FS frame payload.

When the encoded data is encoded data in the downstream burst mode, the first data block at least includes a PSBd and an FS frame header in a downstream physical burst structure, and the second data block at least includes an FS frame payload in the downstream physical burst structure.

In an embodiment, the type of the flexible FEC code is indicated by an HLend field of the FS frame header.

In an embodiment, when the encoded data is encoded data in the continuous transmission mode, the first data block includes an ePSBd and an FECmap structure, and the second data block includes an FS frame.

When the encoded data is encoded data in the downstream burst mode, the first data block includes an ePSBd and an FECmap structure, and the second data block includes a downstream physical burst structure.

In an embodiment, the type of the flexible FEC code is indicated jointly by an FEC type field in the ePSBd and the FECmap structure.

In an embodiment, the type of the flexible FEC code is further indicated by an FEC count field in the ePSBd.

Embodiments of the present application also provide a communication node. The communication node includes a processor, which is configured to, when executing a computer program, perform the method provided in any embodiment of the present application. Specifically, the communication node may be a first communication node or a second communication node. The first communication node includes a processor that, when executing a computer program, is configured to implement the encoding method provided in any embodiment of the present application. The second communication node includes a processor that, when executing a computer program, is configured to implement the decoding method provided in any embodiment of the present application. Exemplarily, the first communication node may be the OLT provided by any of the preceding embodiments, and the second communication node may be the ONU provided by any of the preceding embodiments.

FIG. 26 is a diagram illustrating the structure of a communication node according to an embodiment. As shown in FIG. 26, the communication node includes a processor 60, a memory 61, and a communication interface 62. One or more processors 60 may be provided in the communication node, with one processor 60 shown in FIG. 26 as an example. The processor 60, memory 61, and communication interface 62 in the communication node may be connected via a bus or other means, with a bus connection shown in FIG. 26 as an example. The bus represents one or more of several types of bus structures, including a memory bus or a memory controller, a peripheral bus, an Accelerated Graphics Port (AGP), a processor, or a local bus using any bus structure among multiple bus structures.

As a computer-readable storage medium, the memory 61 may be configured to store software programs, computer-executable programs, and modules, such as program instructions/modules corresponding to the methods in the embodiments of the present application. The processor 60 runs the software programs, instructions, and modules stored in the memory 61 to execute at least one of function applications and data processing of the communication node, that is, to implement the preceding methods.

The memory 61 may include a program storage region and a data storage region. The program storage region may store an operating system and an application program required by at least one function. The data storage region may store data created depending on the use of a terminal. Additionally, the memory 61 may include a high-speed random-access memory and may also include a non-volatile memory, for example, at least one magnetic disk memory, a flash memory, or another non-volatile solid-state memory. In some examples, the memory 61 may include memories that are remotely disposed with respect to the processor 60, and these remote memories may be connected to the communication node via a network. Examples of the preceding network include but are not limited to, the Internet, an intranet, a network, a communication network, and a combination thereof.

The communication interface 62 may be configured to receive and send data.

The embodiments of the present application also provide a computer-readable storage medium. The computer-readable storage medium is configured to store a computer program that, when executed by a processor, implements the methods provided by any one of the embodiments of the present application.

A computer storage medium in this embodiment of the present application may adopt any combination of one or more computer-readable media. The computer-readable medium may be a computer-readable signal medium or a computer-readable storage medium. The computer-readable storage medium may be, for example, but is not limited to, an electrical, magnetic, optical, electromagnetic, infrared or semiconductor system, apparatus, or device, or any combination thereof. The computer readable storage medium includes (a non-exhaustive list) an electrical connection having one or more wires, a portable computer disk, a hard disk, a random access memory (RAM), a read-only memory (ROM), an electrically erasable, programmable read-only memory (EPROM), a flash memory, an optical fiber, a portable compact disk read-only memory (CD-ROM), an optical memory device, a magnetic memory device, or any suitable combination thereof. In the present application, the computer-readable storage medium may be any tangible medium including or storing a program. The program may be used by or used in conjunction with an instruction execution system, apparatus, or device.

A computer-readable signal medium may include a data signal propagated in a baseband or as part of a carrier. The data signal carries computer-readable program codes. The data signal propagated in this manner may be in multiple forms and includes, but is not limited to, an electromagnetic signal, an optical signal or any suitable combination thereof. The computer-readable signal medium may also be any computer-readable medium other than the computer-readable storage medium. The computer-readable medium may send, propagate, or transmit a program used by or used in conjunction with an instruction execution system, apparatus, or device.

Program codes included on the computer-readable medium may be transmitted by using any suitable medium including, but not limited to, a radio medium, a wire, an optical cable, and radio frequency (RF), or any suitable combination thereof.

Computer program codes for executing the operations of the present disclosure may be written in one or more programming languages or a combination of multiple programming languages. The programming languages include object-oriented programming languages (such as Java, Smalltalk, C++, Ruby and Go) and conventional procedural programming languages (such as "C" or similar programming languages). The program codes may be executed entirely on a user computer, partly on a user computer, as a stand-alone software package, partly on a user computer and partly on a remote computer, or entirely on a remote computer or a server. In the case where the remote computer is involved, the remote computer may be connected to the user computer via any type of network (including a local area network (LAN) or a wide area network (WAN)) or may be connected to an external computer (for example, via the Internet through an Internet service provider).

It is to be understood by those skilled in the art that the term user terminal encompasses any suitable type of wireless user device, for example, a mobile phone, a portable data processing apparatus, a portable web browser, or a vehicle-mounted mobile station.

Generally speaking, various embodiments of the present application may be implemented in hardware or special-purpose circuits, software, logic, or any combination thereof. For example, some aspects may be implemented in hardware while other aspects may be implemented in firmware or software executable by a controller, a microprocessor, or another computing apparatus, though the present application is not limited thereto.

Embodiments of the present application may be implemented through the execution of computer program instructions by a data processor of a mobile apparatus, for example, implemented in a processor entity, by hardware, or by a combination of software and hardware. The computer program instructions may be assembly instructions, instruction set architecture (ISA) instructions, machine instructions, machine-related instructions, microcodes, firmware instructions, state setting data, or source or object codes written in any combination of one or more programming languages.

A block diagram of any logic flow among the drawings of the present application may represent program procedures, may represent interconnected logic circuits, modules, and functions, or may represent a combination of program procedures with logic circuits, modules, and functions. Computer programs may be stored in a memory. The memory may be of any type suitable for a local technical environment and may be implemented using any suitable data storage technology, such as, but not limited to, a read-only memory (ROM), a random-access memory (RAM), and an optical memory device and system (a digital video disc (DVD) or a compact disk (CD)). The computer-readable medium may include a non-transitory storage medium. The data processor may be of any type suitable for the local technical environment, such as, but not limited to, a general-purpose computer, a special-purpose computer, a microprocessor, a digital signal processor (DSP), an application-specific integrated circuit (ASIC), a field-programmable gate array (FPGA), and a processor based on multi-core processor architecture.

## Claims

1. An encoding method, the method being applied to a first communication node and comprising:
acquiring an uncoded physical frame, wherein the uncoded physical frame comprises a first data block and a second data block, and the first data block comprises a type of a flexible forward error correction, FEC, code; and
encoding the second data block according to the type of the flexible FEC code.

2. The method according to claim 1, further comprising:
encoding the first data block according to a type of a dedicated FEC code.

3. The method according to claim 1 or 2, further comprising:
sending encoded data to a second communication node, wherein the encoded data comprises the first data block and second type codewords or comprises first type codewords and second type codewords, the first type codewords present the encoded first data block, and the second type codewords present the encoded second data block.

4. The method according to claim 2, wherein the type of the dedicated FEC code is the same as or different from the type of the flexible FEC code.

5. The method according to claim 1, wherein the uncoded physical frame is an uncoded physical frame in a continuous transmission mode or an uncoded physical frame in a downstream burst mode.

6. The method according to claim 5, wherein
when the uncoded physical frame is an uncoded physical frame in the continuous transmission mode, the first data block at least comprises a physical synchronization block, downstream, PSBd, and the second data block at least comprises part of a framing sublayer, FS, frame; and
when the uncoded physical frame is an uncoded physical frame in the downstream burst mode, the first data block at least comprises the PSBd and the second data block at least comprises part of a downstream physical burst structure.

7. The method according to claim 6, wherein the type of the flexible FEC code is indicated by a physical synchronization, PSync, sequence of the PSBd or the type of the flexible FEC code is indicated jointly by a downstream forward error correction, DS FEC, flag bit in an operation and control body, OC body, field of the PSBd and a reserved bit in the OC body field of the PSBd.

8. The method according to claim 5, wherein
when the uncoded physical frame is an uncoded physical frame in the continuous transmission mode, the first data block at least comprises a PSBd and an FS frame header, and the second data block comprises an FS frame payload; and
when the uncoded physical frame is an uncoded physical frame in the downstream burst mode, the first data block at least comprises the PSBd and an FS frame header in a downstream physical burst structure, and the second data block at least comprises an FS frame payload in the downstream physical burst structure.

9. The method according to claim 8, wherein the type of the flexible FEC code is indicated by an HLend field in the FS frame header.

10. The method according to claim 5, wherein
when the uncoded physical frame is an uncoded physical frame in the continuous transmission mode, the first data block comprises an extended physical synchronization block, downstream, ePSBd, and a forward error correction mapping, FECmap, structure, and the second data block comprises an FS frame; and
when the uncoded physical frame is an uncoded physical frame in the downstream burst mode, the first data block comprises the ePSBd and the FECmap structure, and the second data block comprises a downstream physical burst structure.

11. The method according to claim 10, wherein the type of the flexible FEC code is indicated jointly by a forward error correction type, FEC type, field in the ePSBd and the FECmap structure.

12. The method according to claim 11, wherein the type of the flexible FEC code is further indicated by a forward error correction count, FEC count, field in the ePSBd.

13. A decoding method, the method being applied to a second communication node and comprising:
determining a type of a flexible forward error correction, FEC, code; and
decoding second type codewords of encoded data according to the type of the flexible FEC code to obtain a second data block.

14. The method according to claim 13, further comprising:
receiving the encoded data sent by a first communication node, wherein the encoded data comprises a first data block and the second type codewords or comprises first type codewords and the second type codewords.

15. The method according to claim 14, wherein determining the type of the flexible FEC code comprises:
determining the type of the flexible FEC code according to the first data block; or
decoding the first type codewords according to a type of a dedicated FEC code to obtain the first data block, and determining the type of the flexible FEC code according to the first data block.

16. The method according to claim 15, wherein the type of the dedicated FEC code is the same as or different from the type of the flexible FEC code.

17. The method according to claim 14, wherein the encoded data is encoded data in a continuous transmission mode or encoded data in a downstream burst mode.

18. The method according to claim 17, wherein
when the encoded data is encoded data in the continuous transmission mode, the first data block at least comprises a physical synchronization block, downstream, PSBd, and the second data block at least comprises part of a framing sublayer, FS, frame; and
when the encoded data is encoded data in the downstream burst mode, the first data block at least comprises the PSBd, and the second data block at least comprises part of a downstream physical burst structure.

19. The method according to claim 18, wherein the type of the flexible FEC code is indicated by a physical synchronization, PSync, sequence of the PSBd, or the type of the flexible FEC code is indicated jointly by a downstream forward error correction, DS FEC, flag bit in an operation and control body, OC body, field of the PSBd and a reserved bit in the OC body field of the PSBd.

20. The method according to claim 17, wherein
when the encoded data is encoded data in the continuous transmission mode, the first data block at least comprises a PSBd and an FS frame header, and the second data block comprises an FS frame payload; and
when the encoded data is encoded data in the downstream burst mode, the first data block at least comprises the PSBd and an FS frame header in a downstream physical burst structure, and the second data block at least comprises an FS frame payload in the downstream physical burst structure.

21. The method according to claim 20, wherein the type of the flexible FEC code is indicated by an HLend field in the FS frame header.

22. The method according to claim 17, wherein
when the encoded data is encoded data in the continuous transmission mode, the first data block comprises an extended physical synchronization block, downstream, ePSBd, and a forward error correction mapping, FECmap, structure, and the second data block comprises an FS frame; and
when the encoded data is encoded data in the downstream burst mode, the first data block comprises the ePSBd and the FECmap structure, and the second data block comprises a downstream physical burst structure.

23. The method according to claim 22, wherein the type of the flexible FEC code is indicated jointly by a forward error correction type, FEC type, field in the ePSBd and the FECmap structure.

24. The method according to claim 23, wherein the type of the flexible FEC code is further indicated by a forward error correction count, FEC count, field in the ePSBd.

25. A first communication node, comprising: a processor that is configured to, when executing a computer program, implement the encoding method according to any one of claims 1 to 12.

26. A second communication node, comprising: a processor that is configured to, when executing a computer program, implement the decoding method according to any one of claims 13 to 24.

27. A computer-readable storage medium storing a computer program that, when executed by a processor, implements the encoding method according to any one of claims 1 to 12 or the decoding method according to any one of claims 13 to 24.
